# EUROPEAN PATENT SPECIFICATION

(11) **EP 3 934 215 B1**
(45) Date of publication and mention of the grant of the patent: **26.04.2023**
(21) Application number: 20774365.9
(22) Date of filing: 05.03.2020
(51) Int. Cl.: H04M 1/02

(54) **COVER PLATE, DISPLAY SCREEN AND ELECTRONIC DEVICE**
ABDECKPLATTE, ANZEIGEBILDSCHIRM UND ELEKTRONISCHE VORRICHTUNG
PLAQUE DE RECOUVREMENT, ÉCRAN D'AFFICHAGE ET DISPOSITIF ÉLECTRONIQUE

(30) Priority: 19.03.2019 CN 201920353579 U
(43) Date of publication of application: 05.01.2022
(73) Proprietor: GUANGDONG OPPO MOBILE TELECOMMUNICATIONS CORP., LTD., Dongguan, Guangdong 523860 (CN)
(72) Inventor: MU, Sinan, Dongguan, Guangdong 523860 (CN); XU, Lisi, Dongguan, Guangdong 523860 (CN); XIAO, Bo, Dongguan, Guangdong 523860 (CN)
(74) Representative: Manitz Finsterwald Patent- und Rechtsanwaltspartnerschaft mbB
(86) International application number: PCT/CN2020/078050
(87) International publication number: WO 2020/187049

(56) References cited:
- WO-A2-2013/184623
- CN-A- 108 600 459

## Description

### TECHNICAL FIELD

This disclosure relates to the field of electronic products, and more particularly to a cover plate, a display screen, and an electronic device.

### BACKGROUND

A screen of a mobile phone has a cover plate for receiving a touch operation of a user. The cover plate serves as a main component of the front of the mobile phone, the appearance and structure of the cover plate have a great influence on user's visual experience and touch feeling. A cover plate of a traditional mobile phone is relatively monotonous and outdated, which adversely affects the user experience.

WO 2013/184623 A2 relates to a consumer electronic product, which includes: a transparent camera window; a cover formed of glass or ceramic, the cover being integrated with the transparent camera window, wherein the glass or ceramic cover has a substantially smooth exterior surface even across the transparent camera window; a housing coupled with the glass or ceramic cover; and electrical components disposed at least partially internal to the housing, the electrical components including at least a camera.

### SUMMARY

The invention is specified by the independent claims. Further embodiments are specified in the dependent claims.

### BRIEF DESCRIPTION OF THE DRAWINGS

To explain configuration features and effects of the disclosure more clearly, the following describes the disclosure with reference to accompanying drawings and specific implementations in detail.
FIG. 1 is a schematic perspective structural view of a cover plate according to an implementation of the disclosure.
FIG. 2 is a partial enlarged schematic structural view of the cover plate at Circle A in FIG. 1.
FIG. 3 is a partial front view of the cover plate in FIG. 1.
FIG. 4 is another partial front view of the cover plate in FIG. 1.
FIG. 5 is a partial rear view of the cover plate in FIG. 3.
FIG. 6 is an exploded schematic structural view of a display screen according to an implementation of the disclosure.
FIG. 7 is an exploded schematic structural view of a display screen according to another implementation of the disclosure.
FIG. 8 is a schematic perspective structural view of an electronic device according to an implementation of the disclosure.
FIG. 9 is an exploded schematic structural view of the electronic device in FIG. 8.

### DETAILED DESCRIPTION

A cover plate is provided. The cover plate includes a flat portion and a curved portion. The flat portion has a flat front surface and a first side surface. The flat front surface has a first sideline and a second sideline connected with the first sideline. A curved portion is connected with the flat portion. The curved portion is arranged around a periphery of the flat portion and has a curved surface and a second side surface. The curved surface is connected between the flat front surface and the second side surface. The first sideline serves as a boundary line between the curved surface and the flat front surface. The second sideline serves as a boundary line between the flat front surface and the first side surface. The first side surface is in the same direction as the second side surface.

In an implementation, the first sideline and the second sideline are connected end to end to have a closed-loop shape.

In an implementation, the first sideline has a length greater than the second sideline.

In an implementation, the first sideline symmetrically extends at opposite ends of the second sideline.

In an implementation, the curved surface has a gradual-changed curved surface close to the second sideline. The gradual-changed curved surface has a first side and a second side opposite to the first side. The first side is close to the second sideline. The gradual-changed curved surface has a width which gradually decreases from the second side to the first side.

In an implementation, the gradual-changed curved surface is sharp pointed at the first side.

In an implementation, the curved surface has a curved corner. The curved corner is bent to serve as a corner of the cover plate. The curved corner is connected with the second side of the gradual-changed curved surface.

In an implementation, the cover plate has a light incident region and a light shielding region. The light shielding region starts at the first side surface and the second side surface and has a boundary extending into the interior of the flat front surface. The light incident region is between the second sideline and the boundary and is located in the flat portion. The light shielding region surrounds the light incident region, where the light shielding region within a preset range from a periphery of the light incident region is located in the flat portion.

In an implementation, a part of the boundary, which is inside the flat front surface and corresponds to the light incident region, is bent away from the light incident region. The part of the boundary corresponding to the light incident region is in an arc shape.

In an implementation, the cover plate has a bottom surface which is opposite to the flat front surface and connected with the first side surface and the second side surface. The bottom surface has a coating region. The coating region starts at an outline of the bottom surface and has a third sideline and a fourth sideline which are located inside the bottom surface. Both the third sideline and the fourth sideline correspond to an inside part of the flat front surface. The third sideline is located between the outline of the bottom surface and the fourth sideline. The third sideline encloses an enclosed region. The coating region is coated with a light shielding material to form the light shielding region. The enclosed region serves as the light incident region.

In an implementation, the first side surface is flush with and connected with the second side surface.

In an implementation, the first side surface is not flush with the second side surface.

A display screen is further provided. The display screen includes a display panel and the above-mentioned cover plate. The display panel is attached to a surface of the cover plate opposite to the flat front surface.

In an implementation, the cover plate has a light incident region and a light shielding region. The light shielding region starts at the first side surface and the second side surface and has a boundary extending into the exterior of the flat front surface. The light incident region is between the second sideline and the boundary and is located in the flat portion. The light shielding region surrounds the light incident region, where the light shielding region within a preset range from a periphery of the light incident region is located in the flat portion. A region enclosed by the boundary allows light which is emitted from the display panel during displaying to pass through.

In an implementation, the display panel has an outline matching the boundary.

In an implementation, the display panel has an outline matching the cover plate. The display panel defines a through hole. The through hole extends along a thickness direction of the display panel and is aligned with the light incident region.

An electronic device is further provided. The electronic device includes a housing, a display panel, and a cover plate. The housing defines an installation groove therein. The cover plate is laminated with the display panel. The cover plate includes a flat portion and a curved portion. The flat portion has a flat front surface and a first side surface. The flat front surface has a first sideline and a second sideline connected with the first sideline. The curved portion is connected with the flat portion. The curved portion is arranged around a periphery of the flat portion and has a curved surface and a second side surface. The curved surface is connected between the flat front surface and the second side surface. The first sideline serves as a boundary line between the curved surface and the flat front surface. The second sideline serves as a boundary line between the flat front surface and the first side surface. The first side surface is in the same direction as the second side surface. The cover plate and the display panel are both received in the installation groove. The cover plate seals an opening of the installation groove.

In an implementation, the cover plate has a light incident region and a light shielding region. The light shielding region starts at the first side surface and the second side surface and has a boundary extending into the interior of the flat front surface. The light incident region is between the second sideline and the boundary and is located in the flat portion. The light shielding region surrounds the light incident region, where the light shielding region within a preset range from a periphery of the light incident region is located in the flat portion. A region enclosed by the boundary allows light which is emitted from the display panel during displaying to pass through. The electronic device includes a camera. The camera is adjacent to the display panel and located on the same side of the cover plate as the display panel. The camera is aligned with the light incident region to receive light which is incident on the light incident region.

In an implementation, the display panel has an outline matching the boundary.

In an implementation, the housing includes a front housing and a middle frame. The front housing defines the mounting groove therein. The middle frame matches the front housing and is located on a side of the front housing away from the cover plate. The camera is installed on the middle frame or the front housing.

Technical solutions in implementations of the disclosure will be described clearly and completely hereinafter with reference to the accompanying drawings in the implementations of the disclosure. Apparently, the described implementations are merely some rather than all implementations of the disclosure.

According to the implementations of the disclosure, a cover plate of a display screen of an electronic device is provided. The cover plate is arranged on the display panel to protect the display panel, respond to touch control operations, and the like.

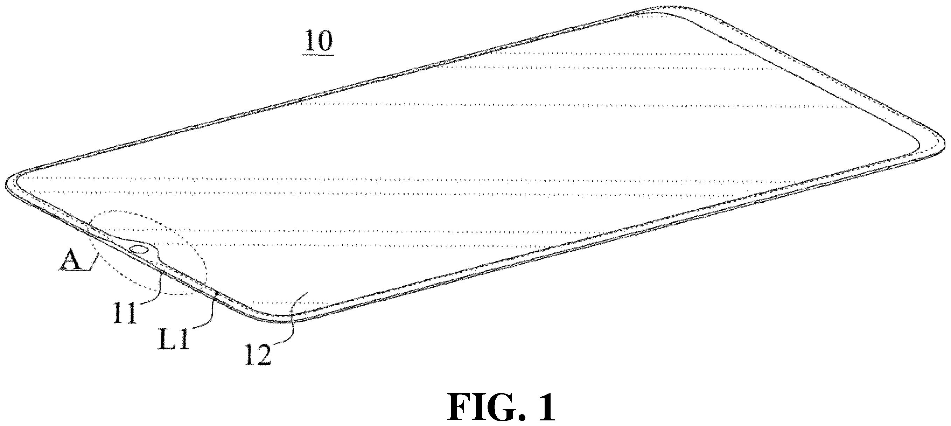

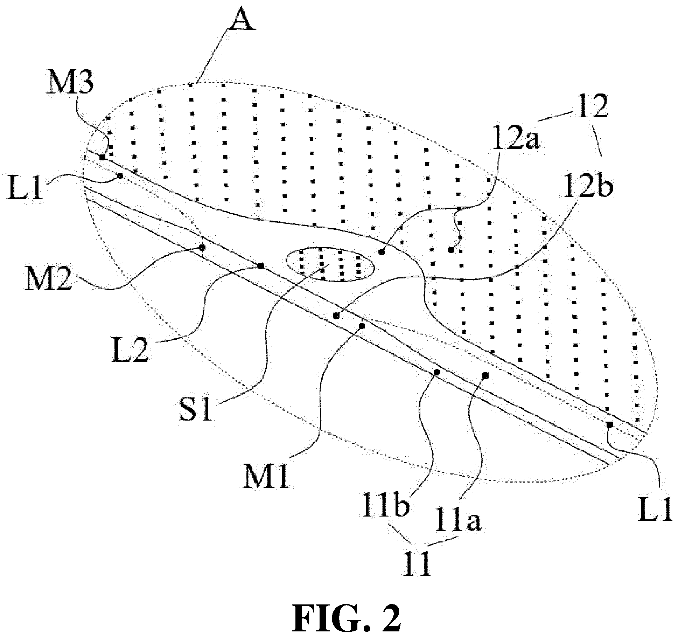

As illustrated in FIG. 1 and FIG. 2, in a first implementation, a cover plate 10 is provided. The overall cover plate 10 can be in a shape of a rectangular flat-plate. The cover plate 10 can be made of glass. The cover plate 10 may also have any other desired shape, and alternatively or additionally, the cover plate 10 may be made of other suitable materials. In an implementation, the cover plate 10 has a flat portion 12 and a curved portion 11. The flat portion 12 is connected with the curved portion 11. The curved portion 11 is arranged around a periphery of the flat portion 12.

As illustrated in FIGS. 1 and 2, the flat portion 12 is in a flat plate shape. The flat portion 12 has two opposite surfaces in the thickness direction thereof, the two opposite surfaces are both planar surfaces. The flat portion 12 has a flat front surface 12a (also known as a flat front exterior surface 12a) and a first side surface 12b. When the terminal device is in use, the flat front surface 12a faces a user and is configured to receive a touch operation of the user. The first side surface 12b is connected with the flat front surface 12a. The first side surface 12b is a planar surface. A normal direction of the first side surface 12b may be perpendicular to the thickness direction of the flat portion 12. The flat front surface 12a has a first sideline L1 and a second sideline L2. The wording "sideline" in the implementations refers to a boundary line of a surface. The first sideline L1 is connected with the second sideline L2. Each of the first sideline L1 and the second sideline L2 can be a straight line or a curved line. As an example, the second sideline L2 is a straight line. In a case that the second sideline L2 is a straight line, the first sideline L1 can be connected to the second sideline L2 directly, or connected to the second sideline L2 indirectly via an intermediate line segment. The curved portion 11 has a curved surface 11a and a second side surface 11b. The curved surface 11a is connected between the flat front surface 12a and the second side surface 11b. The curved surface 11a is curved in a direction away from the flat front surface 12a to have a curvature, and the curvature can be determined according to actual needs. The second side surface 1 1b is a planar surface. Since the curved surface 11a is located at an edge of the flat front surface 12a, the cover plate 10 may be formed in to a 2.5 dimensional (2.5D) glass cover plate. The first sideline L1 serves as a boundary line between the curved surface 11a and the flat front surface 12a. The second sideline L2 serves as a boundary line between the flat front surface 12a and the first side surface 12b. Thus, an edge of the cover plate 10 has both the curved surface 11a and a flat surface (i.e., the flat front surface 12a). The first side surface 12b is in the same direction as the second side surface 11b. In other words, the first side surface 12b has a normal direction which is substantially the same as the second side surface 11b. In an implementation, the first side surface 12b may be flush with and connected to the second side surface 11b. As illustrated in FIG. 2, there are a boundary line M1 and a boundary line M2 between the first side surface 12b and the second side surface 11b. The first side surface 12b and the second side surface 11b form at least part of a side surface of the cover plate 10. Alternatively, the first side surface 12b is not flush with the second side surface 11b. For example, the first side surface 12b protrudes relative to the second side surface 11b to form a boss.

In this implementation, the curved portion 11 may surround all the sidelines of the flat portion 12 except the second sideline L2. Here, as illustrated in FIGS. 1-2, the first sideline L1 and the second sideline L2 together form all the sidelines of the flat portion 12, the second side surface 11b and the first side surface 12b together form all the side surfaces of the cover plate 10. In other implementations, the curved portion 11 may surround part of the sidelines of the flat portion 12 except the second sideline L2. Here, the first sideline L1 and the second sideline L2 together form part of the sidelines of the flat portion 12, the second side surface 11b and the first side surface 12b together form part of the side surfaces of the cover plate 10. In the first implementation, the cover plate 10 is described as having the flat portion 12 and the curved portion 11, this is however merely for ease of description of the structure of the cover plate 10, rather than indicating that the cover plate 10 is formed by combining the flat portion 12 and the curved portion 11 which is separately formed from the flat portion 12. On the contrary, the cover plate 10 is integrally formed.

In the first implementation, the cover plate 10 has the curved portion 11 surrounding the periphery of the flat portion 12. The curved surface 11a of the curved portion 11 is connected with the flat front surface 12a of the flat portion 12 at the first sideline L1. The flat front surface 12a is connected with the first side surface 12b of the flat portion 12 at the second sideline L2. As such, the edge of the cover plate 10 has both the curved surface 11a and a planar surface (i.e., the flat front surface 12a) in appearance, which is different from a traditional cover plate in which an edge is all curved surfaces. The touch feeling of a curved surface part (i.e., the curved surface 11a) is different from that of a planar part (i.e., the flat front surface 12a) of the cover plate 10. When being assembled together with a housing of the electronic device, the curved surface part is engaged with the housing in a manner different from the planar part, so that the curved surface part and the planar part respectively provide different visual experiences. Therefore, the cover plate 10 of the disclosure provides an improved user experience by changing a conventional appearance structure.

As illustrated in FIGS. 1 to 2, in the first implementation, as an example, the first sideline L1 and the second sideline L2 are connected end to end to have a closed-loop shape. That is, two opposite ends of the first sideline L1 are respectively connected to two opposite ends of the second sideline L2. Here, the first sideline L1 and the second sideline L2 together form all the sidelines of the flat front surface 12a. In other words, the curved portion 11 is arranged around all the sidelines of the flat portion 12 except the second sideline L2. The second side surface 11b and the first side surface 12b together form all the side surfaces of the cover plate 10. In other implementations, only one end of the first sideline L1 is connected to one end of the second sideline L2. Here, the first sideline L1 and the second sideline L2 together form part of the sidelines of the flat portion 12. That is, the curved portion 11 is arranged around part of the sidelines of the flat portion 12 except the second sideline L2, the second side surface 11b and the first side surface 12b together form part of the side surfaces of the cover plate 10.

As illustrated in FIGS. 1 to 2, in an implementation, the first sideline L1 has a length greater than the second sideline L2. For example, when the first sideline L1 and the second sideline L2 are enclosed into a closed-loop shape, the first sideline L1 can surround the second sideline L2 which is shorter than the first sideline L1, so that there is the curved surface part arranged at each of the two opposite sides of the planar part of the cover plate 10. With such design, the cover plate 10 has a more balanced structure, more conforms to the principle of ergonomics, can provide a better visual experience, and is convenient for processing. In other implementations, the relationship between the lengths of the first sideline L1 and the second sideline L2 is not limited.

As illustrated in FIGS. 1 to 2, in an implementation, the first sideline L1 is symmetrically extends at opposite ends of the second sideline L2. As such, the curved surface part of the cover plate 10 is symmetrically distributed on the opposite sides of the planar part, such that the cover plate 10 has a symmetrical structure and provides a better visual experience. In other implementations, the first sideline L1 may be asymmetrically distributed relative to the second sideline L2. For example, only one end of the first sideline L1 is connected with the second sideline L2. For another example, the first sideline L1 and the second sideline L2 are connected end to end to have a closed-loop shape, with the second sideline L2 asymmetrically distributed on the opposite sides of the first sideline L1.

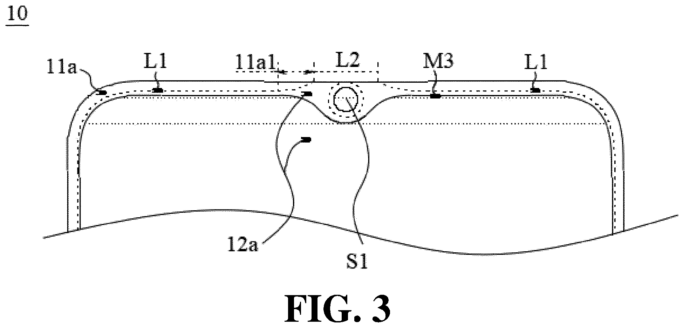

As illustrated in FIG. 3, in the first implementation, as an example, the curved surface 1 1a may has a gradual-changed curved surface 11a1 close to the second sideline L2. The gradual-changed curved surface 11a1 has a first side and a second side opposite to the first side. For example, as illustrated in FIG. 3, the first side refers to the right side of the gradual-changed curved surface 11a1, the second side refers to the left side of the gradual-changed curved surface 11a1. The first side is close to the second sideline L2. The gradual-changed curved surface 11a1 is tapered from the second side to the first side. In other words, the gradual-changed curved surface 11a1 has a width which is gradually narrowed from the second side to the first side. In an implementation, the gradual-changed curved surface 11a1 has an area of zero at the first side, and in this case, the first side can be sharp pointed (that is, be a sharp tip). Such gradual-changed part of the curved surface 11a allows the curved surface 11a to have a smooth transition to the flat front surface 12a. With such design, the cover plate 10 can provide better touch feeling as well as a round and aesthetically pleasing appearance. In this implementation, the second side of the gradual-changed curved surface 11a1 may be close to the second sideline L2. The gradual-changed curved surface 11a1 has a short length in a direction along a sideline of the cover plate 10 (that is, in a left-right direction of FIG. 3). The gradual-changed curved surface 11a1 can be gently tapered. In other implementations, the curved surface 11a may not have the gradual-changed part.

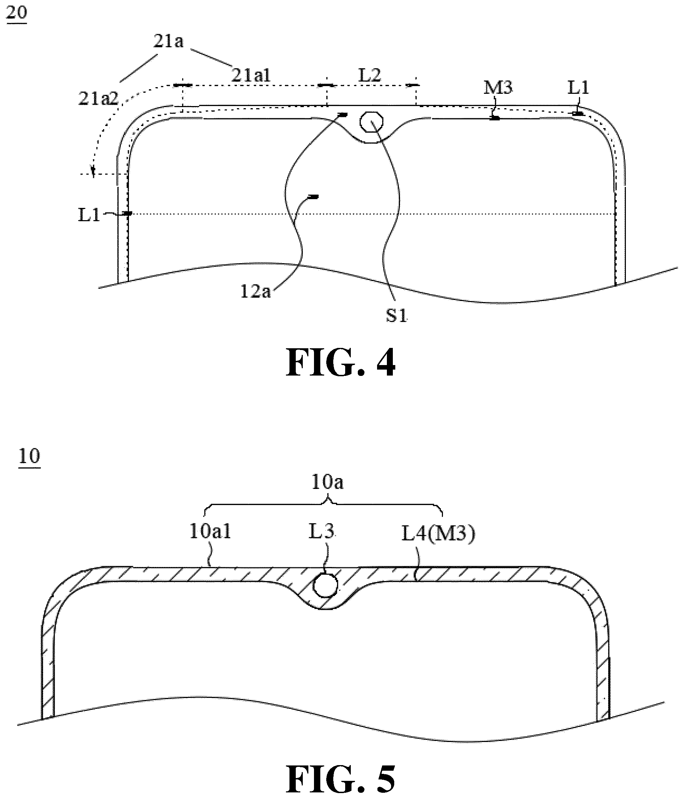

The cover plate 20 in a second implementation is different from the cover plate 20 in the first implementation in the following aspects. As illustrated in FIG. 4, the curved surface 21a of the cover plate 20 may further have a curved corner 21a2. The curved corner 21a2 is bent to serve as a corner of the cover plate 10, where the "corner" is viewed from a direction perpendicular to the flat front surface 12a. The curved corner 21a2 is connected with the second side of the gradual-changed curved surface 21a1. In other words, the gradual-changed curved surface 21a1 has a relatively long length. The second side of the gradual-changed curved surface 21a1 extends to be connected with the corner of the cover plate 10. Since the gradual-changed curved surface 21a1 is lengthened, an enlarged gradual-changed region is available for the user to touch, and thus the touch feeling experience is improved. In addition, the lengthened gradual-changed curved surface 21a1 can create an appealing and eye-catching light effect under lighting and provide good visual experience. In the second implementation, the gradual-changed curved surface 21a1 can be sharply tapered, so that the gradual-changed curved surface 21a1 has a narrow strip shape. The solution of this implementation is not limited thereto.

As illustrated in FIGS. 1 to 4, in this implementation, the cover plate 10 further has a light incident region S1 and a light shielding region.

The light shielding region (a surface region of cover plate 10 except a region with dotted-lines in FIGS. 1 to 4) starts at the first side surface 12b and the second side surface 11b, that is, the first side surface 12b and the second side surface 11b serve as a boundary of the light shielding region. The light shielding region has the boundary M3 extending into the interior of the flat front surface 12a, that is, the boundary M3 of the light shielding region falls inside the flat front surface 12a when viewed from a direction perpendicular to the flat front surface 12a. The light shielding region may have a region falling inside the flat portion 12 and a region falling inside the curved portion 11. As an example, each of two opposite boundaries of the light shielding region may have a closed-loop shape. The light shielding region is an enclosed region. The light shielding region is used to shield portions of elements under the cover plate 10 to avoid affecting displaying of the display screen. For example, the light shielding region can be used to shield a protective frame of the display panel, traces and cables of at least one of the cover plate 10 and the display panel, and portions of elements (such as a camera, a light sensor, etc.) which are under the cover plate 10 and need to be shielded.

The light incident region S1 is between the second sideline L2 and the boundary M3 that falls inside the flat front surface 12a. The light shielding region surrounds the periphery of the light incident region S1. The light incident region S1 allows the external light to pass through to be received by the camera under the cover plate 10, which will be described in detail hereinafter. The light incident region S1 is an enclosed region. The light incident region S1 is located in the flat portion 12. The light shielding region surrounds the light incident region S1, where the light shielding region within a preset range from the periphery of the light incident region S1 is located in the flat portion 12. In other words, a preset range defined by a preset distance from the boundary of the light incident region S1 is located in the flat portion 12. Such preset range, together with the light incident region S1, form a region surrounded by such as the circular dotted line in FIG. 3. When the external light enters the camera through the light incident region S1, since the flat portion 12 is flat within the preset range, the external light will travel in an expected transmission path, so that the external light can enter the camera accurately and reliably, which ensures that an image captured by the camera has good accuracy and without distortion. The preset range can be set on condition that the camera is allowed to receive light reliably and accurately, and can be adjusted according to the model of the camera.

Edges of the traditional cover plate 10 are all formed as the curved surface 11a. In the traditional cover plate 10, in order to ensure that all regions within the preset range are inside the flat portion 12 such that the camera can receive light reliably and accurately, a distance between an inner boundary (for ease of understanding, reference can be made to the first sideline L1 in this implementation) of the curved surface 11a and the boundary of the light incident region S1 is greater than or equal to the preset distance (a surface connected between the inner boundary of the curved surface 11a and the boundary of the light incident region S1 is planar). As a result, in the traditional cover plate 10, a distance between the light incident region S1 and the edge of the cover plate 10 is large, and accordingly, a distance between the boundary M3 of the light shielding region inside the flat front surface 12a and the edge of the cover plate 10 is large, that is, from the perspective shown in FIGS. 3 and 4, the boundary M3 will move downward. As such, in the traditional cover plate 10, the light shielding region will occupy a larger area of the cover plate 10, while a light transparent region (i.e., a region of the cover plate 10 except the light shielding region and the light-incident region S1) will occupy a decreased area of the cover plate 10. When viewing from the front of the display screen, the display area, which matches the light transparent region, is smaller, thus resulting in a low screen-to-body ratio of the display screen and poor viewing experience. In contrast, in this implementation, a region of the cover plate 10 corresponding to the edge of the light incident region S1 is formed into a planar surface rather than the curved surface 11a, an edge of the planar surface serves as an edge of the cover plate 10. Therefore, on the premise of ensuring a sufficient preset distance, the light incident region S1 can be adjacent to the edge of the cover plate 10. Thus, the distance between the boundary M3 of the light shielding region inside the flat front surface 12a and the edge of the cover plate 10 is shortened, that is, from the perspective shown in FIGS. 3 and 4, the boundary M3 will move upward, such that the light shielding region will occupy a decreased area of the cover plate 10, and the light transparent region will occupy an increased area of the cover plate 10. When viewed from the front of the display screen, the display region is large, which increases the screen-to-body ratio of the display screen and improves the viewing experience.

In addition, since the cover plate 10 has the curved portion 11 and the flat portion 12, the curved surface 11a of the curved portion 11 can be formed to have a required curvature through a corresponding process, so as to realize desired visual effect and touch feeling without adversely affecting the distance between the light incident region S1 inside the flat portion 12 and the edge of the cover plate 10. A larger curvature of the curved surface 11a leads to a rounder edge and a more obvious effect of the water droplets on the edge of the cover plate 10. The curvature of the curved surface 11a can be adjusted according to actual needs, which will not adversely affect the screen-to-body ratio of the display screen.

As illustrated in FIGS. 1 to 4, in an implementation, the boundary M3 located inside the flat front surface 12a bends away from the light incident region S1 at a position corresponding to the light incident region S1, so that the boundary M3 has a curved shape such as a water-drop shape at the position corresponding to the light incident region. This design is different from the traditional cover plate 10 in which the light shielding region is designed into a flat-straight strip shape, and provides a distinguishing and attractive visual experience. In an implementation, the water drop-shaped region is symmetrical about a symmetry axis of the cover plate 10, which significantly enhances the aesthetics of the cover plate 10. Combined with the above, when the boundary M3 of the light shielding region inside the flat front surface 12a moves upward, the water drop-shaped region will be "flattened" upward, the distance between a low boundary of the water drop-shaped region and the edge of the cover plate 10 is decreased, and thus the screen-to-body ratio of the display screen can be improved. The light shielding region in this implementation may be in other shapes other than the water drop-shape. As an example, the part of the light shielding region corresponding to the light incident region S1 can be formed into a shape of a straight strip with rounded corners.

In this implementation, the light shielding region of the cover plate 10 can be formed by coating a light shielding material on a bottom surface of the cover plate 10.

As illustrated in FIG. 5, the cover plate 10 has a bottom surface 10a which is opposite to the flat front surface 12a and connected with the first side surface 12a and the second side surface 11b. The bottom surface 10a has a coating region. The coating region starts at an outline 10a1 of the bottom surface 10a and has a third sideline L3 and a fourth sideline L4 which are located inside the bottom surface. As illustrated in FIGS. 1 to 5, both the third sideline L3 and the fourth sideline L4 correspond to an inside part of the flat front surface 12a. Both the third sideline L3 and the fourth sideline L4 fall inside the flat front surface 12a when viewed from a direction perpendicular to the flat front surface 12a. The third sideline L3 is located between the outline 10a1 of the bottom surface 10a and the fourth sideline L4. The third sideline L4 encloses an enclosed region. The coating region is coated with a light shielding material to form the light shielding region. The fourth sideline L4 corresponds to the boundary M3 of the light shielding region which is inside the flat front surface 12a, so that the enclosed region serves as the light incident region S1. The light shielding material includes but is not limited to light block ink. In other implementations, the light shielding region of the cover plate 10 is not limited to being formed in the above manner.

The cover plate 10 in the implementations of the disclosure is described in detail above. The display screen and the electronic device in the implementations of the disclosure will be described in detail below with reference to the accompanying drawings.

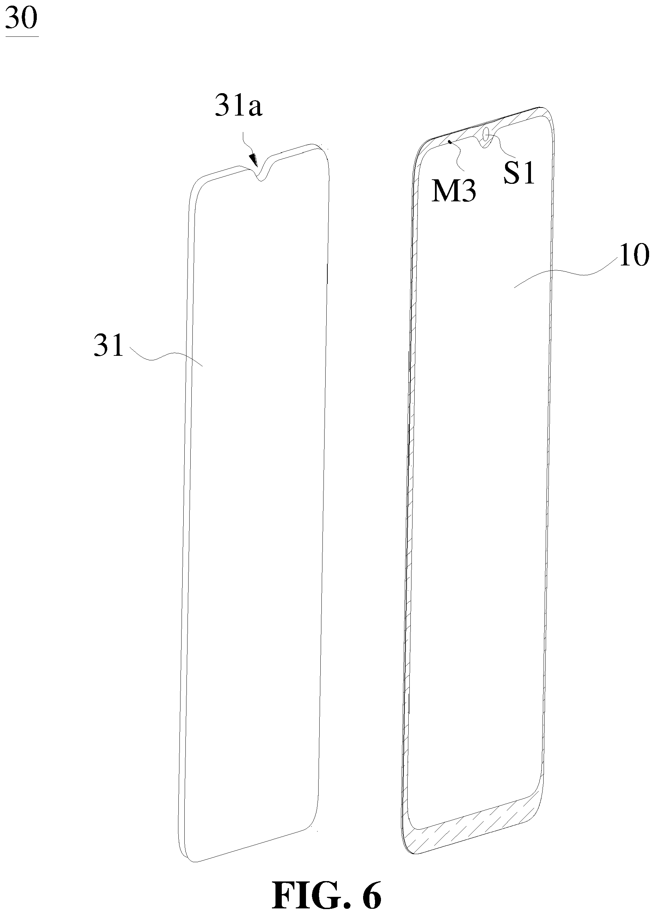

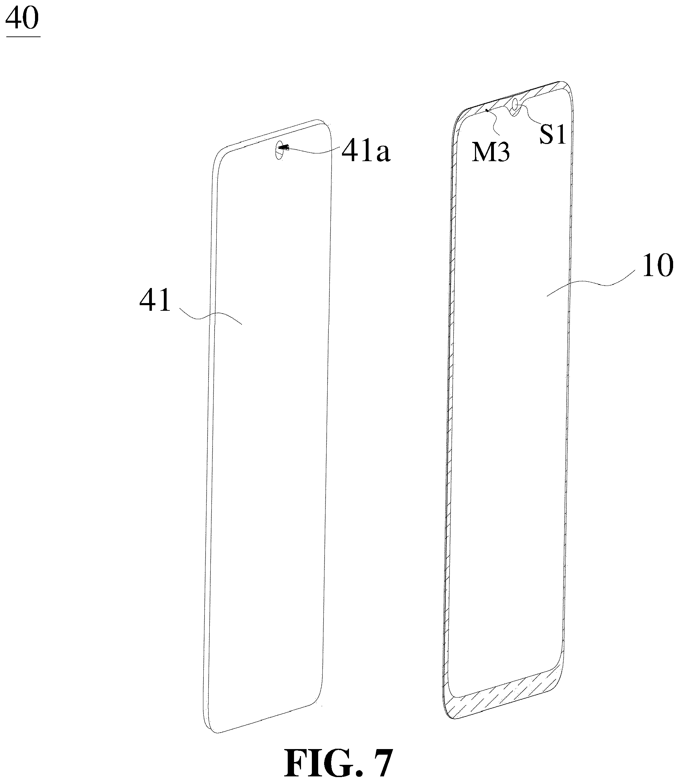

As described in FIGS. 6 and 7, a display screen 30 is provided. The display screen 30 includes a display panel 31 and the cover plate of any of the above-mentioned implementations. The display panel 31 is attached to a surface of the cover plate 10 opposite to the flat front surface. For example, the display panel 31 is attached to the bottom surface 10a of the cover plate 10. The display panel 31 includes, but is not limited to, a liquid crystal display panel, an organic light emitting diode display panel, an ink screen panel, and the like. The display screen 30 of this implementation has a distinguishing and attractive appearance, which brings a differentiated touch feeling and visual effect to the user, and improves the user experience.

In an implementation, the display screen 30 may include the above-mentioned cover plate having the light incident region S1 and the light shielding region. The cover plate 10 is taken as an example, the cover plate 10 of the display screen 30 has the light incident region S1 and the light-shielding region. The light shielding region starts at the first side surface 12b and the second side surface 11b and has a boundary M3 extending into the interior of the flat front surface 12a. The light incident region S1 is between the second sideline L2 and the boundary M3 and is located in the flat portion 12. The light shielding region surrounds the light incident region S1, where the light shielding region within a preset range from the periphery of the light incident region S1 is located in the flat portion 12. A region enclosed by the boundary M3 (i.e., the light transparent region) allows light emitted from the display panel 31 during displaying to pass through. For this type of display screen 30, since a larger the display panel 31 can be adopted to match the light transparent region, the display screen 30 has a higher screen-to-body ratio, and the viewing experience is improved. In addition, the curved surface 11a of the cover plate 10 in the display screen 30 can be designed to have different curvatures according to requirements without affecting the screen-to-body ratio of the display screen 30.

As illustrated in FIG. 6, in the first implementation, the display panel 31 has an outline matching the boundary M3 of the light shielding region. That is, the outline of the display panel 31 matches the light transparent region to allow the light emitted from the display panel 31 during displaying to pass through the light transparent region. For example, in a case that the light transparent region has a drop-shaped notch, the display panel 31 also has a notch 31a at a position corresponding to the drop-shaped notch. The camera is disposed in the notch 31a and aligned with the light incident region S1 of the cover plate 10 to receive the external light. Different from a conventional display panel in a regular shape, the display panel 31 in the first implementation has a special shape to improve the screen-to-body ratio. Such structural design of the display panel 31 is optional rather than necessary.

Alternatively, a display panel 41 in the second implementation is illustrated as FIG. 7. The display panel 41 in FIG. 7 is different from the display panel 31 in the first implementation as follows. The display panel 41 has an outline matching the cover plate 10. In other words, the display panel 41 has a regular outline. The display panel 41 defines a through hole 41a. The through hole 41a extends along a thickness direction of the display panel 41 and is aligned with the light incident region S1. The through hole 41a is used to install the camera so that the camera can receive external light incident through the light incident region S1. The display panel 41 in the second implementation is a panel with holes, which can also improve the screen-to-body ratio. Such structural design of the display panel 41 is also optional rather than necessary.

According to the implementations of the disclosure, an electronic device is further provided. The electronic device includes but not limited to an electronic product such as a mobile phone, a tablet computer, an E-Reader, a remote controller, a notebook computer, an in-vehicle device, an Internet TV, a wearable device, and the like. In an implementation, the electronic device is a mobile phone.

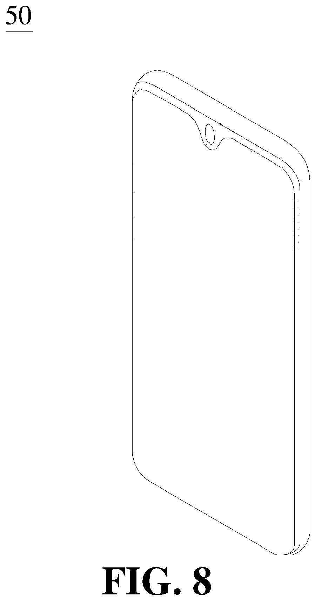

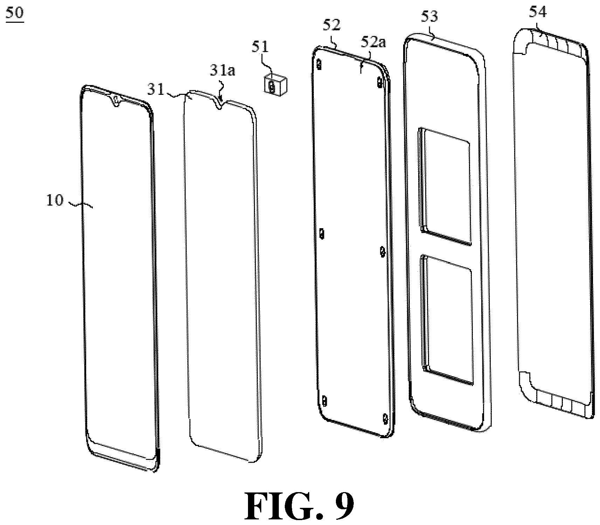

As illustrated in FIGS. 8 and 9, the electronic device 50 includes a housing and the display screen described in any of the above implementations. The display screen 30 is taken as an example. The display screen 30 in the electronic device 50 includes the cover plate 10 and the display panel 31. The cover plate 10 includes a flat portion 12 and a curved portion 11 connected with the flat portion 12. The curved portion 11 is arranged around a periphery of the flat portion 12. The flat portion 12 has a flat front surface 12a and a first side surface 12b. The flat front surface 12a has a first sideline L1 and a second sideline L2 connected with the first sideline L1. The curved portion has a curved surface 11a and a second side surface 11b. The curved surface 11a is connected between the flat front surface 12a and the second side surface 11b. The first sideline L1 serves as a boundary line between the curved surface 11a and the flat front surface 12a. The second sideline L2 serves as a boundary line between the flat front surface 12a and the first side surface 12b. The first side surface 12b is in the same direction as the second side surface 11b. The display panel 31 is laminated with the cover plate 10. The housing defining an installation groove therein. The cover plate 10 and the display panel 31 are both received in the installation groove. The cover plate 10 seals an opening of the installation groove. The display screen 30 of the electronic device 50 in this implementation has a distinguishing and attractive appearance, which brings a differentiated touch feeling and visual effect to the user, and improves the user experience.

In an implementation, the electronic device 50 includes a camera 51. The camera 51 is adjacent to the display panel 31 and located on the same side of the cover plate 10 as the display panel 31. The camera 51 is aligned with the light incident region S1 to receive light which is incident on and pass through the light incident region S1. The electronic device 50 has a higher screen-to-body ratio, and the viewing experience is improved. In addition, the curved surface 11a of the cover plate 10 in the display screen 50 can be designed to have different curvatures according to actual needs without affecting the screen-to-body ratio of the display screen 30.

As illustrated in FIG. 9, the outline of the display panel 31 matches the light transparent region of the cover plate 10 to allow the light emitted from the display panel 31 during displaying to pass through the light transparent region. For example, in a case that the light transparent region has a drop-shaped notch, the display panel 31 is also has a notch 31a at a position corresponding to the drop-shaped notch. The camera is disposed in the notch 31a and aligned with the light incident region S1 of the cover plate 10 to receive the external light. Different from a conventional display panel 31 in a regular shape, the display panel 31 in this implementation has a special shape to improve the screen-to-body ratio. It is noted that, such structural design of the display panel 31 is optional rather than necessary.

As illustrated in FIG. 9, in an implementation, the housing can include a front housing 52 and a middle frame 53. The front housing 52 defines the mounting groove 52a therein. The middle frame 53 matches the front housing 52 and is located on a side of the front housing 52 away from the cover plate 10. The camera is installed on the middle frame 53 or the front housing 52. The housing can further include a rear housing 54. The rear housing 54 matches the middle frame 53 and is located on a side of the middle frame 53 away from the front housing 52. The housing in such structure can carry more components, so that the overall electronic device 50 has a high structural strength. The rear housing 54 can be detachable, so that the user can open the rear housing 54 to replace a battery or other components such as a memory card, a SIM card, etc. It is noted that, such structural design of the housing is also optional rather than necessary.

## Claims

1. A cover plate (10), comprising:
a flat portion (12) having a flat front surface (12a) and a first side surface (12b), wherein the flat front surface (12a) has a first sideline (L1) and a second sideline (L2) connected with the first sideline (L1); and
a curved portion (11) connected with the flat portion (12), wherein the curved portion (11) is arranged around a periphery of the flat portion (12) and has a curved surface (11a) and a second side surface (11b), the curved surface (11a) is connected between the flat front surface (12a) and the second side surface (11b), wherein the first sideline (L1) serves as a boundary line (M1) between the curved surface (11a) and the flat front surface (12a), the second sideline (L2) serves as a boundary line (M2) between the flat front surface (12a) and the first side surface (12b), and the first side surface (12b) is in the same direction as the second side surface (11b);
the cover plate (10) has a light incident region (S1) and a light shielding region surrounding the light incident region (S1), and the light incident region (S1) allows external lights to pass through, the light shielding region is coated with a light shielding material;
a region of the cover plate (10) between the light incident region (S1) and the second sideline (L2) is directly connected with and perpendicular to the first side surface (12b).

2. The cover plate (10) of claim 1, wherein the first sideline (L1) and the second sideline (L2) are connected end to end to have a closed-loop shape.

3. The cover plate (10) of claim 2, wherein the first sideline (L1) has a length greater than the second sideline (L2).

4. The cover plate (10) of claim 2, wherein the first sideline (L1) symmetrically extends at opposite ends of the second sideline (L2).

5. The cover plate (10) of claim 1, wherein
the curved surface (11a, 21a) has a gradual-changed curved surface (11a1, 21a1) close to the second sideline (L2), wherein the gradual-changed curved surface (11a1, 21a1) has a first side and a second side opposite to the first side, wherein the first side is close to the second sideline (L2), and the gradual-changed curved surface (11a1, 21a1) has a width which gradually decreases from the second side to the first side.

6. The cover plate (10) of claim 5, wherein the gradual-changed curved surface (11a1, 21a1) is sharp pointed at the first side.

7. The cover plate (10) of claim 5, wherein the curved surface (21a) has a curved corner (21a2), the curved corner (21a2) is bent to serve as a corner of the cover plate (10), and the curved corner (21a2) is connected with the second side of the gradual-changed curved surface (21a1).

8. The cover plate (10) of any of claims 1-7, wherein
the light shielding region starts at the first side surface (12b) and the second side surface (11b) and has a boundary extending into the interior of the flat front surface (12a);
the light incident region (S1) is between the second sideline (L2) and the boundary and is located in the flat portion (12); and
the light shielding region within a preset range from a periphery of the light incident region (S1) is located in the flat portion (12).

9. The cover plate (10) of claim 8, wherein a part of the boundary, which is inside the flat front surface (12a) and corresponds to the light incident region (S1), is bent away from the light incident region (S1), and the part of the boundary corresponding to the light incident region (S1) is in an arc shape.

10. The cover plate (10) of claim 8, having a bottom surface (10a) which is opposite to the flat front surface (12a) and connected with the first side surface (12b) and the second side surface (11b), wherein
the bottom surface (10a) has a coating region, wherein the coating region starts at an outline of the bottom surface (10a) and has a third sideline (L3) and a fourth sideline (L4) which are located inside the bottom surface (10a);
both the third sideline (L3) and the fourth sideline (L4) correspond to an inside part of the flat front surface (12a), the third sideline (L3) is located between the outline of the bottom surface (10a) and the fourth sideline (L4), and the third sideline (L3) encloses an enclosed region; and
the coating region is coated with a light shielding material to form the light shielding region, the enclosed region serves as the light incident region (S1).

11. The cover plate (10) of claim 1, wherein
the first side surface (12b) is flush with and connected with the second side surface (11b); or
the first side surface (12b) is not flush with the second side surface (11b).

12. A display screen (30), comprising a display panel (31) and the cover plate (10) of any of claims 1-11, the display panel (31) being attached to a surface of the cover plate (10) opposite to the flat front surface (12a).

13. The display screen (30) of claim 12, wherein the cover plate (10) has a light incident region (S1) and a light shielding region, wherein
the light shielding region starts at the first side surface (12b) and the second side surface (11b) and has a boundary extending into the interior of the flat front surface (12a);
the light incident region (S1) is between the second sideline (L2) and the boundary and is located in the flat portion (12);
the light shielding region surrounds the light incident region (S1), wherein the light shielding region within a preset range from the periphery of the light incident region (S1) is located in the flat portion (12); and
a region enclosed by the boundary allows light which is emitted from the display panel (31) during displaying to pass through.

14. An electronic device (50), comprising:
a housing defining an installation groove therein;
a display panel (31); and
a cover plate (10) of any of claims 1-11, wherein the cover plate (10) is laminated with the display panel (31);
wherein the cover plate (10) and the display panel (31) are both received in the installation groove, the cover plate (10) seals an opening of the installation groove.

15. The electronic device (50) of claim 14, wherein the cover plate (10) has a light incident region (S1) and a light shielding region, wherein
the light shielding region starts at the first side surface (12b) and the second side surface (11b) and has a boundary extending into the interior of the flat front surface (12a);
the light incident region (S1) is between the second sideline (L2) and the boundary and is located in the flat portion (12);
the light shielding region surrounds the light incident region (S1), wherein the light shielding region within a preset range from the periphery of the light incident region (S1) is located in the flat portion (12);
a region enclosed by the boundary allows light which is emitted from the display panel (31) during displaying to pass through; and
the electronic device (50) comprises a camera (51), wherein the camera (51) is adjacent to the display panel (31) and located on the same side of the cover plate (10) as the display panel (31), the camera (51) is aligned with the light incident region (S 1) to receive light which is incident on the light incident region (S1).

## Patentansprüche

1. Abdeckplatte (10), umfassend:
einen flachen Abschnitt (12), der eine flache vordere Fläche (12a) und eine erste Seitenfläche (12b) aufweist, wobei die flache vordere Fläche (12a) eine erste Seitenlinie (L1) und eine zweite Seitenlinie (L2), die mit der ersten Seitenlinie (L1) verbunden ist, aufweist; und
einen gekrümmten Abschnitt (11), der mit dem flachen Abschnitt (12) verbunden ist, wobei der gekrümmte Abschnitt (11) um einen Umfang des flachen Abschnitts (12) angeordnet ist und eine gekrümmte Fläche (11a) und eine zweite Seitenfläche (11b) aufweist, wobei die gekrümmte Fläche (11a) zwischen der flachen vorderen Fläche (12a) und der zweiten Seitenfläche (11b) verbunden ist, wobei die erste Seitenlinie (L1) als eine Grenzlinie (M1) zwischen der gekrümmten Fläche (11a) und der flachen vorderen Fläche (12a) dient, wobei die zweite Seitenlinie (L2) als eine Grenzlinie (M2) zwischen der flachen vorderen Fläche (12a) und der ersten Seitenfläche (12b) dient, und wobei die erste Seitenfläche (12b) in derselben Richtung wie die zweite Seitenfläche (11b) ist;
wobei die Abdeckplatte (10) ein Lichteinfallgebiet (S1) und ein das Lichteinfallgebiet (S1) umgebendes Lichtabschirmgebiet aufweist, und wobei das Lichteinfallgebiet (S1) externe Lichter durchlässt, wobei das Lichtabschirmgebiet mit einem Lichtabschirmmaterial beschichtet ist;
wobei ein Gebiet der Abdeckplatte (10) zwischen dem Lichteinfallgebiet(S1) und der zweiten Seitenlinie (L2) direkt mit der ersten Seitenfläche (12b) verbunden und senkrecht zu dieser ist.

2. Abdeckplatte (10) nach Anspruch 1, wobei die erste Seitenlinie (L1) und die zweite Seitenlinie (L2) Ende an Ende verbunden sind, so dass sie eine Form einer geschlossenen Schleife aufweisen.

3. Abdeckplatte (10) nach Anspruch 2, wobei die erste Seitenlinie (L1) eine größere Länge als die zweite Seitenlinie (L2) aufweist.

4. Abdeckplatte (10) nach Anspruch 2, wobei sich die erste Seitenlinie (L1) symmetrisch an gegenüberliegenden Enden der zweiten Seitenlinie (L2) erstreckt.

5. Abdeckplatte (10) nach Anspruch 1, wobei
die gekrümmte Fläche (11a, 21a) eine sich allmählich ändernde gekrümmte Fläche (11a1, 21a1) nahe der zweiten Seitenlinie (L2) aufweist, und wobei die sich allmählich ändernde gekrümmte Fläche (11a1, 21a1) eine erste Seite und ein zweite Seite gegenüber der ersten Seite aufweist, wobei sich die erste Seite nahe der zweiten Seitenlinie (L2) befindet und die sich allmählich ändernde gekrümmte Fläche (11a1, 21a1) eine Breite aufweist, die sich allmählich von der zweiten Seite zu der ersten Seite verringert.

6. Abdeckplatte (10) nach Anspruch 5, wobei die sich allmählich ändernde gekrümmte Fläche (11a1, 21a1) auf der ersten Seite spitz zulaufend ist.

7. Abdeckplatte (10) nach Anspruch 5, wobei die gekrümmte Fläche (21a) eine gekrümmte Ecke (21a2) aufweist, wobei die gekrümmte Ecke (21a2) gebogen ist, um als eine Ecke der Abdeckplatte (10) zu dienen, und wobei die gekrümmte Ecke (21a2) mit der zweiten Seite der sich allmählich ändernden gekrümmten Fläche (21a1) verbunden ist.

8. Abdeckplatte (10) nach einem der Ansprüche 1-7, wobei
das Lichtabschirmgebiet an der ersten Seitenfläche (12b) und der zweiten Seitenfläche (11b) beginnt und eine Grenze aufweist, die sich in das Innere der flachen vorderen Fläche (12a) erstreckt;
sich das Lichteinfallgebiet (S1) zwischen der zweiten Seitenlinie (L2) und der Grenze befindet und in dem flachen Abschnitt (12) angeordnet ist; und
das Lichtabschirmgebiet innerhalb eines voreingestellten Bereichs von einem Umfang des Lichteinfallgebiets (S1) in dem flachen Abschnitt (12) angeordnet ist.

9. Abdeckplatte (10) nach Anspruch 8, wobei ein Teil der Grenze, der sich innerhalb der flachen vorderen Fläche (12a) befindet und dem Lichteinfallgebiet (S1) entspricht, von dem Lichteinfallgebiet (S1) weg gebogen ist, und wobei der Teil der Grenze, der dem Lichteinfallgebiet (S1) entspricht, eine Bogenform aufweist.

10. Abdeckplatte (10) nach Anspruch 8, die eine untere Fläche (10a) aufweist, die der flachen vorderen Fläche (12a) gegenüberliegt und mit der ersten Seitenfläche (12b) und der zweiten Seitenfläche (11b) verbunden ist, wobei
die untere Fläche (10a) ein Beschichtungsgebiet aufweist, wobei das Beschichtungsgebiet an einem Umriss der unteren Fläche (10a) beginnt und eine dritte Seitenlinie (L3) und eine vierte Seitenlinie (L4) aufweist, die innerhalb der unteren Fläche (10a) angeordnet sind;
sowohl die dritte Seitenlinie (L3) als auch die vierte Seitenlinie (L4) einem inneren Teil der flachen vorderen Fläche (12a) entsprechen, wobei die dritte Seitenlinie (L3) zwischen dem Umriss der unteren Fläche (10a) und der vierten Seitenlinie (L4) angeordnet ist und die dritte Seitenlinie (L3) ein umschlossenes Gebiet umschließt; und
das Beschichtungsgebiet mit einem Lichtabschirmmaterial beschichtet ist, um das Lichtabschirmgebiet auszubilden, wobei das umschlossene Gebiet als das Lichteinfallgebiet (S1) dient.

11. Abdeckplatte (10) nach Anspruch 1, wobei
die erste Seitenfläche (12b) mit der zweiten Seitenfläche (11b) bündig und verbunden ist; oder
die erste Seitenfläche (12b) nicht mit der zweiten Seitenfläche (11b) bündig ist.

12. Anzeigebildschirm (30), umfassend eine Anzeigetafel (31) und die Abdeckplatte (10) nach einem der Ansprüche 1-11, wobei die Anzeigetafel (31) an einer Fläche der Abdeckplatte (10) gegenüber der flachen vorderen Fläche (12a) angebracht ist.

13. Anzeigebildschirm (30) nach Anspruch 12, wobei die Abdeckplatte (10) ein Lichteinfallgebiet (S1) und ein Lichtabschirmgebiet aufweist, wobei
das Lichtabschirmgebiet an der ersten Seitenfläche (12b) und der zweiten Seitenfläche (11b) beginnt und eine Grenze aufweist, die sich in das Innere der flachen vorderen Fläche (12a) erstreckt;
sich das Lichteinfallgebiet (S1) zwischen der zweiten Seitenlinie (L2) und der Grenze befindet und in dem flachen Abschnitt (12) angeordnet ist;
das Lichtabschirmgebiet das Lichteinfallgebiet (S1) umgibt, wobei das Lichtabschirmgebiet innerhalb eines voreingestellten Bereichs von dem Umfang des Lichteinfallgebiets (S1) in dem flachen Abschnitt (12) angeordnet ist; und
ein durch die Grenze umschlossenes Gebiet Licht, das von der Anzeigetafel (31) während eines Anzeigens emittiert wird, durchlässt.

14. Elektronische Vorrichtung (50), umfassend:
ein Gehäuse, das eine Montagenut darin definiert;
eine Anzeigetafel (31); und
eine Abdeckplatte (10) nach einem der Ansprüche 1-11, wobei die Abdeckplatte (10) mit der Anzeigetafel (31) laminiert ist;
wobei die Abdeckplatte (10) und die Anzeigetafel (31) beide in der Montagenut aufgenommen sind, wobei die Abdeckplatte (10) eine Öffnung der Montagenut abdichtet.

15. Elektronische Vorrichtung (50) nach Anspruch 14, wobei die Abdeckplatte (10) ein Lichteinfallgebiet (S1) und ein Lichtabschirmgebiet aufweist, wobei
das Lichtabschirmgebiet an der ersten Seitenfläche (12b) und der zweiten Seitenfläche (11b) beginnt und eine Grenze aufweist, die sich in das Innere der flachen vorderen Fläche (12a) erstreckt;
sich das Lichteinfallgebiet (S1) zwischen der zweiten Seitenlinie (L2) und der Grenze befindet und in dem flachen Abschnitt (12) angeordnet ist;
das Lichtabschirmgebiet das Lichteinfallgebiet (S1) umgibt, wobei das Lichtabschirmgebiet innerhalb eines voreingestellten Bereichs von dem Umfang des Lichteinfallgebiets (S1) in dem flachen Abschnitt (12) angeordnet ist;
ein durch die Grenze umschlossenes Gebiet Licht, das von der Anzeigetafel (31) während eines Anzeigens emittiert wird, durchlässt; und
die elektronische Vorrichtung (50) eine Kamera (51) umfasst, wobei die Kamera (51) an die Anzeigetafel (31) angrenzt und auf derselben Seite der Abdeckplatte (10) wie die Anzeigetafel (31) angeordnet ist, wobei die Kamera (51) mit dem Lichteinfallgebiet (S1) ausgerichtet ist, um Licht aufzunehmen, das auf das Lichteinfallgebiet (S1) einfällt.

## Revendications

1. Plaque de recouvrement (10), comprenant :
une partie plate (12) ayant une surface avant plate (12a) et une première surface latérale (12b), dans laquelle la surface avant plate (12a) a une première ligne latérale (L1) et une deuxième ligne latérale (L2) reliée à la première ligne latérale (L1) ; et
une partie courbe (11) reliée à la partie plate (12), dans laquelle la partie courbe (11) est disposée autour d'une périphérie de la partie plate (12) et a une surface courbe (11a) et une seconde surface latérale (11b), la surface courbe (11a) est reliée entre la surface avant plate (12a) et la seconde surface latérale (11b), dans laquelle la première ligne latérale (L1) sert de limite (M1) entre la surface courbe (11a) et la surface avant plate (12a), la deuxième ligne latérale (L2) sert de limite (M2) entre la surface avant plate (12a) et la première surface latérale (12b), et la première surface latérale (12b) est dans la même direction que la seconde surface latérale (11b) ;
la plaque de recouvrement (10) a une région d'incidence de lumière (S1) et une région de protection contre la lumière entourant la région d'incidence de lumière (S1), et la région d'incidence de lumière (S1) permet à la lumière extérieure de passer à travers, la région de protection contre la lumière est revêtue d'un matériau de protection contre la lumière ;
une région de la plaque de recouvrement (10) entre la région d'incidence de lumière (S1) et la deuxième ligne latérale (L2) est directement reliée à et perpendiculaire à la première surface latérale (12b).

2. Plaque de recouvrement (10) selon la revendication 1, dans laquelle la première ligne latérale (L1) et la deuxième ligne latérale (L2) sont reliées de bout en bout pour présenter une forme en boucle fermée.

3. Plaque de recouvrement (10) selon la revendication 2, dans laquelle la première ligne latérale (L1) a une longueur supérieure à celle de la deuxième ligne latérale (L2).

4. Plaque de recouvrement (10) selon la revendication 2, dans laquelle la première ligne latérale (L1) s'étend symétriquement à des extrémités opposées de la deuxième ligne latérale (L2).

5. Plaque de recouvrement (10) selon la revendication 1, dans laquelle
la surface courbe (11a, 21a) a une surface courbe à changement graduel (liai, 21a1) proche de la deuxième ligne latérale (L2), dans laquelle la surface courbe à changement graduel (liai, 21a1) a un premier côté et un second côté opposé au premier côté, dans laquelle le premier côté est proche de la deuxième ligne latérale (L2), et la surface courbe à changement graduel (liai, 21a1) a une largeur qui diminue graduellement du second côté vers le premier côté.

6. Plaque de recouvrement (10) selon la revendication 5, dans laquelle la surface courbe à changement graduel (liai, 21a1) a une arête aigüe sur le premier côté.

7. Plaque de recouvrement (10) selon la revendication 5, dans laquelle la surface courbe (21a) a un angle courbe (21a2), l'angle courbe (21a2) est fléchi pour servir d'angle de la plaque de recouvrement (10), et l'angle courbe (21a2) est relié au second côté de la surface courbe à changement graduel (21a1).

8. Plaque de recouvrement (10) selon l'une quelconque des revendications 1 à 7, dans laquelle
la région de protection contre la lumière commence à la première surface latérale (12b) et à la seconde surface latérale (11b) et a une limite s'étendant dans l'intérieur de la surface avant plate (12a) ;
la région d'incidence de lumière (S1) se trouve entre la deuxième ligne latérale (L2) et la limite et est située dans la partie plate (12) ; et
la région de protection contre la lumière dans une plage prédéfinie de la région d'incidence de lumière (S1) est située dans la partie plate (12).

9. Plaque de recouvrement (10) selon la revendication 8, dans laquelle une partie de la limite, qui se trouve à l'intérieur de la surface avant plate (12a) et correspond à la région d'incidence de lumière (S1), est fléchie à distance de la région d'incidence de lumière (S1), et la partie de la limite correspondant à la région d'incidence de lumière (S1) est en forme d'arc.

10. Plaque de recouvrement (10) selon la revendication 8, ayant une surface inférieure (10a) qui est opposée à la surface avant plate (12a) et reliée à la première surface latérale (12b) et à la seconde surface latérale (11b), dans laquelle
la surface inférieure (10a) a une région de revêtement, dans laquelle la région de revêtement commence à un contour de la surface inférieure (10a) et a une troisième ligne latérale (L3) et une quatrième ligne latérale (L4) qui sont situées à l'intérieur de la surface inférieure (10a) ;
la troisième ligne latérale (L3) et la quatrième ligne latérale (L4) correspondent toutes deux à une partie intérieure de la surface avant plate (12a), la troisième ligne latérale (L3) est située entre le contour de la surface inférieure (10a) et la quatrième ligne latérale (L4), et la troisième ligne latérale (L3) entoure une région fermée ; et
la région de revêtement est revêtue d'un matériau de protection contre la lumière pour former la région de protection contre la lumière, la région fermée sert de région d'incidence de lumière (S1).

11. Plaque de recouvrement (10) selon la revendication 1, dans laquelle
la première surface latérale (12b) est alignée avec et reliée à la seconde surface latérale (11b) ; ou
la première surface latérale (12b) n'est pas alignée avec la seconde surface latérale (11b).

12. Écran d'affichage (30), comprenant un panneau d'affichage (31) et la plaque de recouvrement (10) selon l'une quelconque des revendications 1 à 11, le panneau d'affichage (31) étant fixé à une surface de la plaque de recouvrement (10) opposée à la surface avant plate (12a).

13. Écran d'affichage (30) selon la revendication 12, dans lequel la plaque de recouvrement (10) a une région d'incidence de lumière (S1) et une région de protection contre la lumière, dans lequel
la région de protection contre la lumière commence à la première surface latérale (12b) et à la seconde surface latérale (11b) et a une limite s'étendant dans l'intérieur de la surface avant plate (12a) ;
la région d'incidence de lumière (S1) se trouve entre la deuxième ligne latérale (L2) et la limite et est située dans la partie plate (12) ;
la région de protection contre la lumière entoure la région d'incidence de lumière (S1), dans lequel la région de protection contre la lumière dans une plage prédéfinie de la région d'incidence de lumière (S1) est située dans la partie plate (12) ; et
une région entourée par la limite permet à la lumière qui est émise depuis le panneau d'affichage (31) pendant l'affichage de passer à travers.

14. Dispositif électronique (50), comprenant :
un logement définissant une rainure d'installation en son sein ;
un panneau d'affichage (31) ; et
une plaque de recouvrement (10) selon l'une quelconque des revendications 1 à 11, dans lequel la plaque de recouvrement (10) est stratifiée avec le panneau d'affichage (31) ;
dans lequel la plaque de recouvrement (10) et le panneau d'affichage (31) sont tous deux reçus dans la rainure d'installation, la plaque de recouvrement (10) scelle une ouverture de la rainure d'installation.

15. Dispositif électronique (50) selon la revendication 14, dans lequel la plaque de recouvrement (10) a une région d'incidence de lumière (S1) et une région de protection contre la lumière, dans lequel
la région de protection contre la lumière commence à la première surface latérale (12b) et à la seconde surface latérale (11b) et a une limite s'étendant dans l'intérieur de la surface avant plate (12a) ;
la région d'incidence de lumière (S1) se trouve entre la deuxième ligne latérale (L2) et la limite et est située dans la partie plate (12) ;
la région de protection contre la lumière entoure la région d'incidence de lumière (S1), dans lequel la région de protection contre la lumière dans une plage prédéfinie de la région d'incidence de lumière (S1) est située dans la partie plate (12) ;
une région entourée par la limite permet à la lumière qui est émise depuis le panneau d'affichage (31) pendant l'affichage de passer à travers ; et
le dispositif électronique (50) comprend une caméra (51), dans lequel la caméra (51) est adjacente au panneau d'affichage (31) et située sur le même côté de la plaque de recouvrement (10) que le panneau d'affichage (31), la caméra (51) est alignée avec la région d'incidence de lumière (S1) pour recevoir la lumière qui est incidente sur la région d'incidence de lumière (S1).
